# EUROPEAN PATENT APPLICATION

(11) **EP 4 730 397 A1**
(43) Date of publication of application: **22.04.2026**
(21) Application number: 24207299.9
(22) Date of filing: 17.10.2024
(51) Int. Cl.: H01L 23/00

(54) **INTEGRATED CIRCUIT**

(71) Applicant: Infineon Technologies AG, 85579 Neubiberg (DE)
(72) Inventor: LEUSCHNER, Stephan, 4020 Linz (AT); TADDIKEN, Hans, 81737 München (DE)
(74) Representative: 2SPL Patentanwälte PartG mbB

(57) **Abstract**

Provided is an integrated circuit (IC) comprising at least one die comprising a transistor layer including a plurality of transistors, a connection pad disposed on the die. The connection pad overlaps the transistor layer along a thickness direction of the IC. The transistor layer comprises a cut-out area free of transistors. The cut-out area faces the connection pad along said thickness direction.

## Description

### Field

The present disclosure generally relates to integrated circuit design and, more particularly, to the design of integrated circuits (ICs) and Wafer-Level Packages (WLP) which can be used for high voltage RF switches and/or antenna tuners.

### Background

In the rapidly evolving domain of semiconductor technology, 3DIC (Three-Dimensional Integrated Circuit) and WLP (Wafer Level Packaging) represent cutting-edge advancements that allow for more compact, efficient, and powerful electronic devices. 3DIC technology involves stacking multiple layers of ICs vertically, creating a three-dimensional architecture that enhances performance and functionality while reducing the footprint of the device. This approach may be particularly advantageous in applications where space is at a premium and high performance is critical, such as in mobile communications, high-performance computing, and advanced signal processing.

WLP complements 3DIC technology by enabling the integration of these multi-layered circuits into a single package directly on the wafer. This method reduces the need for individual chip packaging, thereby minimizing the overall size and improving the electrical performance of the device. In the context of antenna tuners, also known as an antenna matching unit, a device which may be used in radio communication systems to match an impedance of a radio transmitter with an antenna, the integration of 3DICs within WLP allows for the creation of highly efficient, compact, and robust RF (Radio Frequency) components that are essential for maintaining signal integrity and improving communication quality.

A challenge in 3DIC technology, particularly in the design of integrated antenna tuners, is the issue of parasitic coupling capacitance that occurs within the 3DIC. This unwanted capacitance arises from close proximity of transistors to metal pads used for connecting the circuit to external components or other layers within the 3DIC structure. Parasitic coupling capacitance can degrade the performance of the RF components by altering the intended electrical characteristics of the circuit, such as the off-state capacitance (COFF), which is a critical parameter in determining the efficiency and reliability of the antenna tuner.

The presence of high parasitic coupling capacitance can lead to signal loss, reduced bandwidth, and increased noise, all of which negatively impact the overall performance of the antenna tuner. This problem becomes more pronounced in 3DICs due to the increased density of components and the closer proximity of different circuit layers.

Thus, there is a need of effectively mitigating the effects of parasitic coupling, ensuring that the antenna tuner operates with optimal performance in its intended applications.

### Summary

This need is addressed by wafer-level packages in accordance with the appended claims.

According to a first aspect, the present disclosure provides an IC. The IC comprises at least one die comprising a transistor layer including a plurality of transistors (e.g., RF switch transistors). The IC also comprises a connection pad (metal pad) disposed on the die. The connection pad overlaps the transistor layer along a thickness direction of the IC. The transistor layer comprises a cut-out area free of transistors. The cut-out area faces the connection pad along the thickness direction. In other words, the IC includes at least one chip (or die) with a layer of transistors. On top of this chip, there is a connection (metal) pad, which sits above the transistor layer when viewed from the side. In the layer of transistors, there is a specific area where no transistors are placed. This empty area is directly underneath the connection pad when viewed from the side.

The present disclosure introduces an IC that includes at least one die, which is a single unit of semiconductor material containing a transistor layer composed of multiple transistors, such as RF switch transistors. Additionally, the IC is equipped with a connection pad that is positioned on the die. This connection pad is aligned over the transistor layer, following the vertical or thickness direction of the IC. A key feature of the proposed design is the incorporation of a cut-out area within the transistor layer. This cut-out area is intentionally left free of transistors and is situated beneath the connection pad. The purpose of the cut-out area is to face the connection pad along the thickness direction of the IC, thereby reducing the parasitic effects that could arise from the overlap between the transistors and the pad. By omitting transistors from this specific region, the IC aims to mitigate issues such as parasitic coupling capacitance, which can degrade the performance of RF components.

According to some embodiments, the plurality of transistors is arranged in a grid pattern within the transistor layer. The cut-out area is created by omitting transistors from predetermined portions of this grid pattern. This configuration may allow for precise control over which transistors are removed, optimizing a trade-off between the reduction of parasitic capacitance and maintaining sufficient transistor density for adequate performance.

According to some embodiments, the cut-out area extends radially from the center of the connection pad when viewed along the thickness direction. This radial extension may help to uniformly distribute the reduction in parasitic capacitance, which can further enhance the RF performance by ensuring a consistent electrical environment around the connection pad.

According to some embodiments, the cut-out area is smaller than the area of the connection pad. By making the cut-out area smaller than the connection pad, the design may retain some transistors beneath the pad, which can help maintain a balance between reducing capacitance and preserving on-resistance (RON) characteristics. This may allow for a fine-tuned compromise between reducing capacitance and maintaining sufficient electrical performance.

According to some embodiments, the cut-out area may only be partial, meaning that the transistor layer still includes at least one transistor facing the connection pad along the thickness direction. This partial cut-out allows for the retention of some transistor functionality directly beneath the pad, which can be beneficial in maintaining certain electrical characteristics while still achieving a reduction in parasitic capacitance. The advantage is that it provides a balanced approach, allowing for partial improvement in performance without completely sacrificing transistor density under the pad.

According to some embodiments, the cut-out area is larger than the area of the connection pad. This larger cut-out area may maximize the reduction in parasitic capacitance by removing more transistors, which can be particularly beneficial in applications where minimizing capacitance is critical for performance. A greater reduction in parasitic effects may lead to potentially higher efficiency in RF operations.

According to some embodiments, the cut-out area has a drop configuration, where a main portion has a generally circular or elliptical shape, and a secondary portion extends from the main portion and tapers away. This drop-shaped configuration can help in focusing the reduction of parasitic capacitance in critical areas while allowing for some transistors to remain in less critical regions. An advantage is a targeted reduction in capacitance, which can improve specific performance parameters while maintaining overall functionality.

According to some embodiments, the cut-out area can have various shapes, including circular, rectangular, or polygonal. This variety in shape may allow the design to be adapted to different application requirements, providing flexibility in how the parasitic capacitance is managed. An advantage is the ability to customize the IC design to suit different performance needs, leading to optimized outcomes for various applications.

According to some embodiments, the IC further comprises an ultra-thick metal (UTM) arranged between the connection pad and the transistor layer, where the thickness of the UTM is greater than that of the connection pad. The presence of the UTM serves as an additional barrier to parasitic coupling, further reducing unwanted capacitance between the transistor layer and the connection pad. The advantage is an enhanced reduction in parasitic effects, leading to even better RF performance.

According to some embodiments, the UTM is electrically connected to the connection pad. This electrical connection may help to improve the overall electrical performance by providing a direct pathway for current, which can further reduce parasitic effects.

According to some embodiments, the UTM is floating. A floating UTM does not electrically connect to the connection pad, which can help in reducing coupling capacitance without affecting the mechanical stability of the pad.

According to some embodiments, the IC also includes an under-bump metallization (UBM) for a terminal of the IC, with the UBM overlapping the connection pad along the thickness direction. The UBM may provide additional mechanical and electrical stability to the terminal, which can be beneficial in high-frequency applications where reliable connections are crucial.

According to some embodiments, the IC is a 3DIC, which also comprises a second die coupled to the first die. The second die includes a second transistor layer with a second plurality of transistors, forming a transistor stack with the first transistor layer. This 3D configuration allows for a higher density of transistors in a compact footprint, enabling more powerful and complex circuits. An advantage is a significant increase in functionality and performance within a smaller area, which is essential for advanced applications like RF antenna tuners.

According to some embodiments, the IC is a two-dimensional (2D) IC. In a 2D configuration, the IC still benefits from the cut-out design to reduce parasitic capacitance but in a simpler, more traditional layout. The advantage is that it provides similar performance improvements in a more straightforward design, which may be easier to manufacture and integrate.

According to a further aspect of the present disclosure, an antenna tuner is proposed that comprises the IC as described in any of the previous embodiments. The transistor layer in this tuner forms all or part of a radiofrequency (RF) switch. This integration of the IC into an antenna tuner leverages the reduced parasitic capacitance to improve the performance of the RF switch, leading to more efficient and reliable signal tuning. An advantage is enhanced signal quality and device performance, which is critical in communication systems.

Some embodiments of the present disclosure propose a simple layout solution to reduce the coupling between the pad and the transistor layer (e.g., RF switch FETs) by using customized cut-outs in the transistor array (only) on the 3DIC top die.

### Brief description of the Figures

Some examples of apparatuses and/or methods will be described in the following by way of example only, and with reference to the accompanying figures, in which
- Fig. 1: shows a cross-sectional view of a 3DIC for use in RF applications;
- Fig. 2-9: show cross-sectional views of the 3D-IC of Figure 1 illustrating sequential process steps of an example manufacturing process;
- Fig. 10A: shows a cross-sectional view of a 3DIC;
- Fig. 10B: shows a view of a Single-Pole Double-Throw (SPDT) for tuner application;
- Fig. 11A: shows a cross-sectional view of a 3DIC according to a first embodiment;
- Fig. 11B: shows a view of a SPDT for tuner application with cut-out areas;
- Fig. 12: shows a cross-sectional view of a 3DIC according to a second embodiment;
- Fig. 13: shows a cross-sectional view of a 3DIC according to a third embodiment; and
- Fig. 14: shows a cross-sectional view of a 3DIC according to a fourth embodiment.

### Detailed Description

Some examples are now described in more detail with reference to the enclosed figures. However, other possible examples are not limited to the features of these embodiments described in detail. Other examples may include modifications of the features as well as equivalents and alternatives to the features. Furthermore, the terminology used herein to describe certain examples should not be restrictive of further possible examples.

Throughout the description of the figures same or similar reference numerals refer to same or similar elements and/or features, which may be identical or implemented in a modified form while providing the same or a similar function. The thickness of lines, layers and/or areas in the figures may also be exaggerated for clarification.

When two elements A and B are combined using an "or", this is to be understood as disclosing all possible combinations, i.e. only A, only B as well as A and B, unless expressly defined otherwise in the individual case. As an alternative wording for the same combinations, "at least one of A and B" or "A and/or B" may be used. This applies equivalently to combinations of more than two elements.

If a singular form, such as "a", "an" and "the" is used and the use of only a single element is not defined as mandatory either explicitly or implicitly, further examples may also use several elements to implement the same function. If a function is described below as implemented using multiple elements, further examples may implement the same function using a single element or a single processing entity. It is further understood that the terms "include", "including", "comprise" and/or "comprising", when used, describe the presence of the specified features, integers, steps, operations, processes, elements, components and/or a group thereof, but do not exclude the presence or addition of one or more other features, integers, steps, operations, processes, elements, components and/or a group thereof.

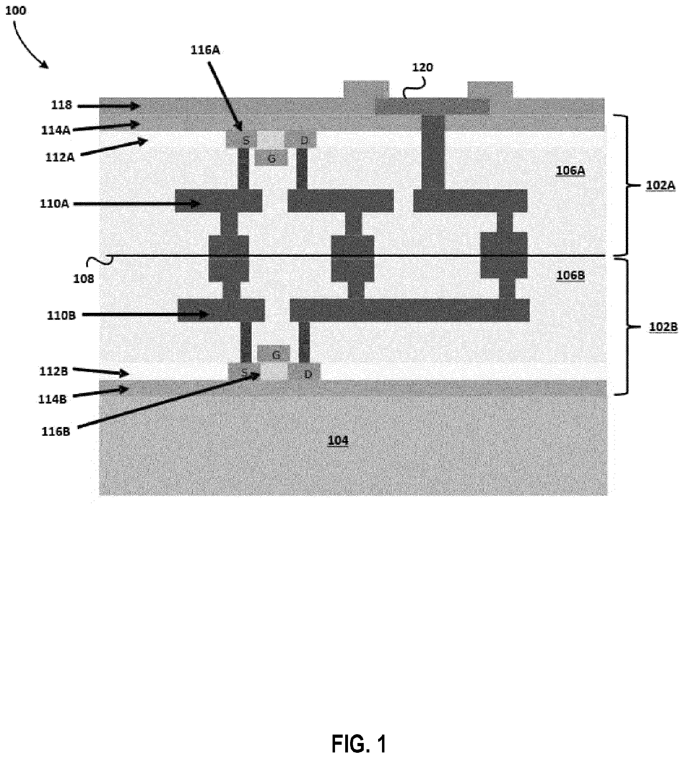

**Fig. 1** is a cross-sectional view of an example 3DIC 100 for use in RF applications. For example, 3DIC 100 may implement an RF switch and/or an antenna tuner.

3DIC is a technology in microelectronics that stacks silicon wafers or dies and interconnects them vertically to form a single integrated circuit. This approach contrasts with traditional flat, 2D chip designs. In a 3DIC, multiple layers of active electronic components are stacked vertically. This is different from traditional 2D ICs where everything is fabricated on a single plane. Vertical integration may allow for a more compact design, reducing the footprint of the chip.

Through-Silicon Vias (TSVs) are a key technology in 3DICs. They are conductive pathways that go through the silicon wafers or dies, enabling electrical connections between different layers of the stack. By reducing the distance that electrical signals need to travel between components, 3DICs can operate at higher speeds and with lower power consumption compared to traditional 2D ICs. This may be particularly beneficial for high-performance computing and mobile devices. Stacking layers of components allows for a higher density of transistors within a given footprint. This means more functionality can be packed into a smaller space.

The illustrative 3DIC 100 of Fig. 1 comprises a first die or chip (chip 1) 102A in an upper position, and a second die or chip (chip 2) 102B in a lower position. A mold wafer 104 is attached to a bottom surface of chip 2 102B. Chip 1 102A includes a first dielectric layer 106A, and chip 2 102B includes a second dielectric layer 106B. Chip 1 102A and chip 2 102B are joined together at the exposed surfaces of the first dielectric layer 106A and the second dielectric layer 106B through bond interface 108 which may include TSVs. Chip 1 102A includes a metal wiring layer 110A that includes a horizontal metal layer as well as a plurality of vertical metal vias. In some embodiments, chip 1 102A can also include one or more additional metal wiring layers. Chip 2 102A includes a metal wiring layer 110B that includes a horizontal metal layer as well as a plurality of metal vias. In some embodiments, chip 2 102B can also include one or more additional metal wiring layers. Chip 1 102A includes a shallow trench isolation (STI) layer 112A for isolating a plurality of transistors such as RF-transistor 116A. Chip 2 102B also includes a similar shallow trench isolation (STI) layer 112B for isolating a plurality of transistors such as RF-transistor 116B. Chip 1 102A further includes a first buried oxide (BOX) layer 114A, and chip 2 102B further includes a similar buried layer, second buried oxide (BOX) layer 114B. In an embodiment, chip 1 102 is passivated with passivation layer 118, and can include one or more metal pads, such as die pad 120.

The silicon handling wafer of chip1 102A (not shown in Fig. 1 and described in greater detail below) may be finally removed down to the first buried oxide (BOX) layer 114A. In some embodiments, the silicon handling wafer of chip 2 is typically not removed. To ensure RF performance, an expensive trap-rich-high-resistivity wafer (TR-HR-Wafer) may be used as substrate for chip 2.

A performance of the 3DIC 100 may be increased by removing the silicon handling wafer below chip 2 102 and bonding chip 2 102B to mold wafer 104. Other materials such aluminum nitride AIN, aluminum oxide Al₂O₃, or glass (SiO₂) can also be used instead of the mold wafer 104. Advantageously RF performance can be increased but a cost reduction may also be realized, because a more cost effective SOI-wafer can be used instead of the expensive TR-HR-Wafer in some embodiments. In some embodiments process acts to provide a substrate contact can also be skipped for further cost reductions.

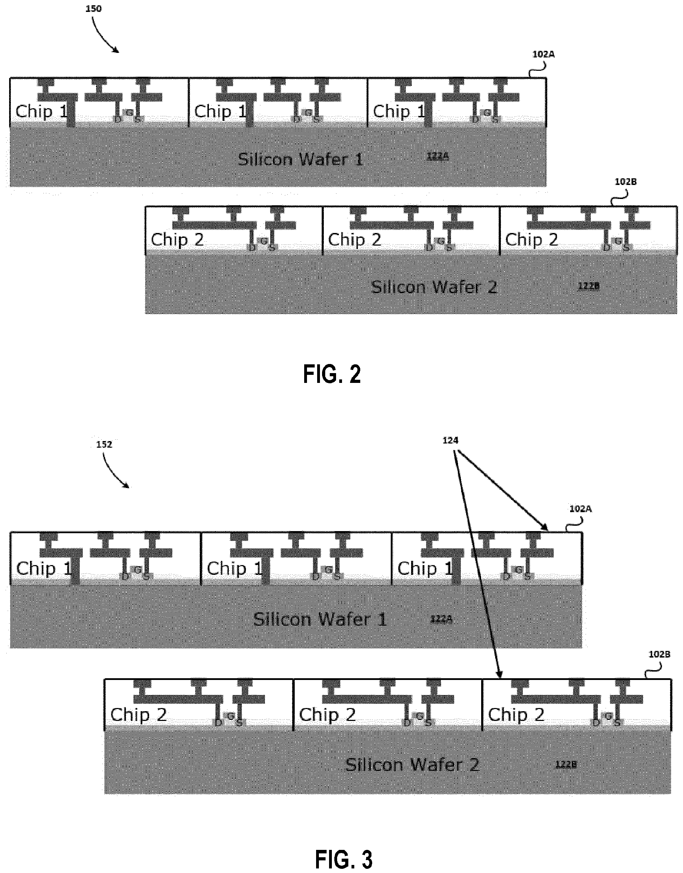

An example manufacturing flow for the 3DIC 100 is described below with respect to sequential processing steps shown in cross-sectional views in Figs. 2 to 9.

**Fig. 2** illustrates a first processing step 150, wherein a plurality of first chips chip 1 102A and a plurality of second chips chip 2 102B are manufactured on corresponding different SOI doped silicon handing wafers 122A, 122B. These SOI doped silicon handling wafers are less expensive than specialty RF handling wafers. Silicon wafer 1 122A includes a plurality of identical chips of chip 1 102A. As previously described, chip 1 102A comprises circuitry portions of an RF-switch and/or an RF-tuner. Silicon wafer 2 122B includes a plurality of identical chips of chip 2 102B. As previously described, chip 2 102B comprises different circuitry portions of an RF-switch and/or an RF-tuner, such that the combination of chip 1 102A and chip 2 102B encompass all of the circuit components of the RF-switch and/or RF-tuner.

**Fig. 3** illustrates a second processing step 152, wherein silicon wafer 1 122A and silicon wafer 2 122B are prepared for wafer bonding. In particular, the top surface 124 of the plurality of chips (chip 1 102A and chip 2 102B) may be polished to achieve smooth top surfaces.

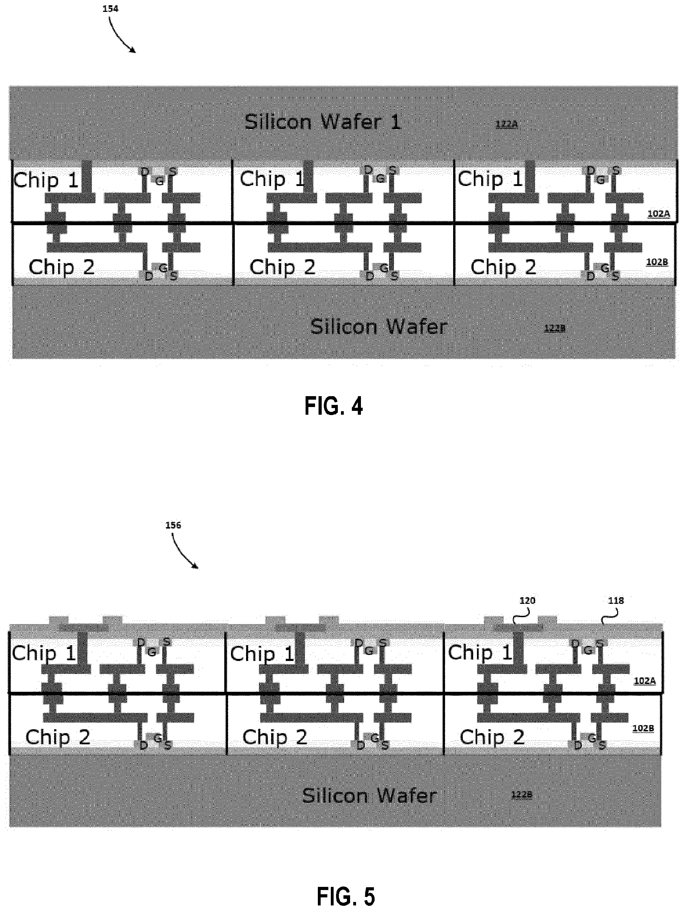

**Fig. 4** illustrates a third processing step 154, wherein silicon wafer 1 122A and silicon wafer 2 122B are bonded together. In an embodiment, silicon wafer 1 122A is vertically flipped and precisely aligned onto silicon wafer 2 122B, such that all corresponding metal contact points are properly arranged. In third processing step 154, plasma activation may be used to prepare the polished surfaces of silicon wafer 1 122A and silicon wafer 2 122B for bonding. Bonding at bond interface 108 may be accomplished using a hybrid bonding tool.

**Fig. 5** illustrates a fourth processing step 156, wherein silicon wafer 1 122A is removed by grinding and/or etching down to the first BOX layer 114A. Once silicon wafer 1 122A has been removed, depositing and structuring of pad-metallization for die pad 120 may be performed. Once one or more die pads 120 are formed, depositing and structuring of passivation layer 118 may be performed.

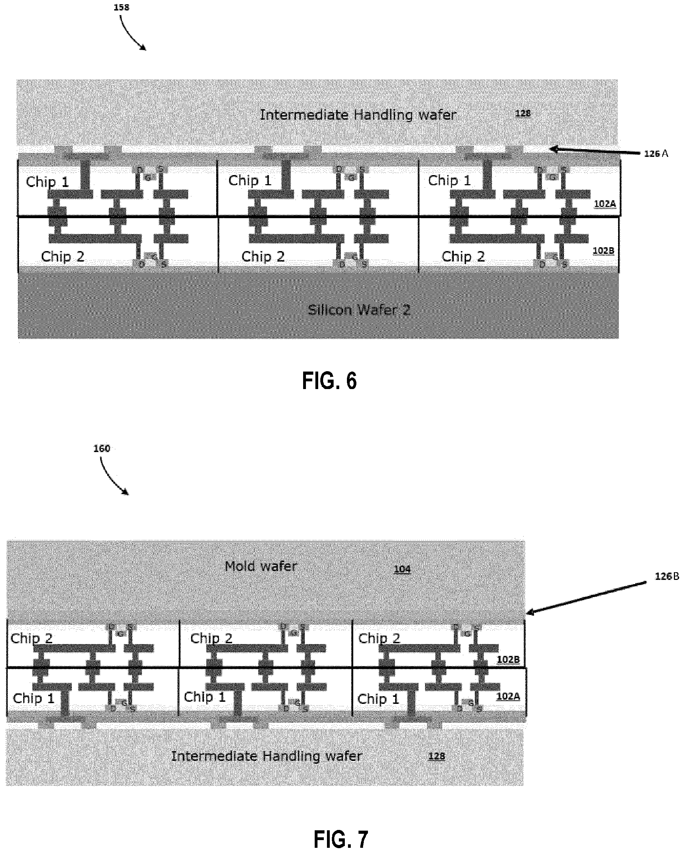

**Fig. 6** illustrates a fifth processing step 158, wherein an intermediate handling wafer 128 (e.g. a glass wafer) may be mounted on the top side of the plurality of chips (chip 1 102A) using an adhesive tape or glue layer 126A. Processing step 158 is optional and may be omitted.

**Fig. 7** illustrates a sixth processing step 160, wherein the plurality of mounted wafers are flipped, and silicon wafer 2 122B is removed. The removal can be implemented, for example, by grinding and/or etching down to second BOX layer 114B. A new handling wafer is mounted on the new top side of the mounted wafers (top surface of flipped chip 2 102B). In some embodiments, the new handling wafer can comprise a mold wafer 104 of a wafer comprising aluminum nitride (AIN), Aluminum oxide (Al₂O₃), or glass (SiO₂). The new handling wafer 104 can be mounted by using a glue layer 126B or an adhesive tape. Processing step 160 is optional and may be omitted.

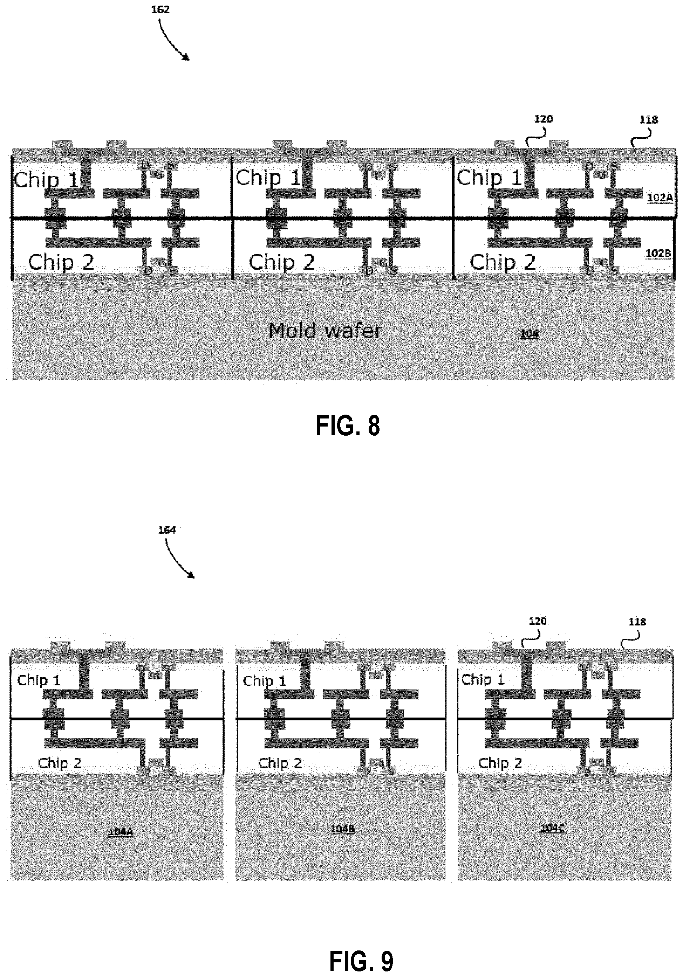

**Fig. 8** illustrates a seventh processing step 162, wherein the mounted wafers are flipped again to the original orientation, and the intermediate handling wafer 128 is removed. Once the intermediate handling wafer 128 is removed, the top surface of the plurality of chips (chip 1 102A) is cleaned. Processing step 162 is optional and may be omitted.

**Fig. 9** illustrates an eighth processing step 164, wherein singularization of the individual bonded chips (chip 1 102A and chip 2) and corresponding portions of the mold wafer (104A, 104B, and 104C) or Silicon wafer 122B is performed. Singularization can be performed, for example, by sawing, laser cutting, or etching.

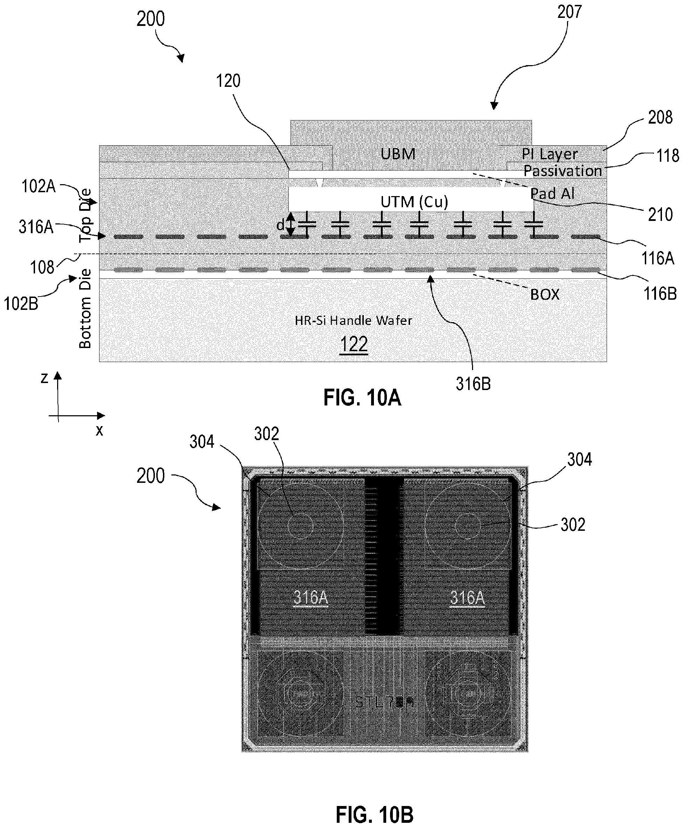

The individual 3DICs can then be packaged into individual wafer level packages or fabricated in a hybrid circuit along with other supporting components (not shown). An example of a resulting individual wafer level package (WLP) is shown in Fig. 10A. The WLP comprises an IC 200. In the example of Fig. 10A, the IC 200 is a 3DIC, such as 3DIC 100. Embodiments are not limited to 3DICs. The skilled person having benefit from the present disclosure will appreciate that the IC could also be a 2DIC.

The 3DIC 200 of the WLP shown in Fig. 10A comprises a wafer, such as a Silicon wafer 122, mold wafer 104, or a handling wafer. The 3DIC 200 further comprises a (bottom) die 102B located on top of wafer 122 and comprising a first transistor layer 316B with a first plurality of RF switch transistors (e.g., FETs) 116B, e.g. of an RF switch. Bottom die 102B is mechanically coupled to wafer 122. Wafer 122 acts as substrate for (bottom) die 102B. 3DIC 200 further comprises a (top) die 102A located on top of die 102B and comprising a second transistor layer 316A with a second plurality of RF switch transistors 116A of the RF switch. The dies 102A and 102B are stacked on top of each other and bonded together through bonding interface 108. 3DIC 200 may be implemented as part of an antenna tuner, as described below in further reference to Fig. 10B.

The 3DIC 200 shown in Fig. 10A further comprises at least one die pad 120 (e.g., a metal pad) which is electrically connected to top die 102A. Die pads, also known as bond pads or chip pads, may serve as the primary interface for electrical connection between the 3DIC 200 and the outside world. The primary function of die pads is to provide electrical connections for the integrated circuit (IC) (e.g., RF switch transistors 116A) on the 3DIC 200. Each pad may be connected to a specific part of the circuit within the die and allows for the transfer of electrical signals (such as power, ground, and data) between the IC and external circuits. Die pad 120 may be made of materials that have high electrical conductivity, such as Aluminum (Al), Copper (Cu), etc. In the illustrated example, die pad 120 is located on a top surface of the top die.

In the example of Fig. 10A, the top die 102A of 3DIC 200 further comprises an ultra-thick metal (UTM) 210 arranged in the die 102A between the die pad 120 and the RF transistors 116A. UTM refers to metal layers that are significantly thicker than the standard metal layers 110A, 110B used in typical semiconductor manufacturing processes. While standard metal layers in semiconductor devices might range from a few nanometers to a few micrometers in thickness, UTMs 210 can be several micrometers to tens of micrometers thick, e.g., 2 µm to 20 µm. Common materials for UTMs include copper, aluminum, and sometimes gold or silver. In power electronics, such as RF switches, UTMs may be used to handle high current densities. They may reduce resistive losses and improve heat dissipation. In the example of Fig. 10A, UTM 210 is directly electrically coupled to the die pad 120, for example by means of connecting vias. A thickness of the UTM 210 is greater than a thickness of the die pad 120. A lateral width of the UTM 210 underneath the die pad 120 may substantially be equal to the lateral width of the die pad 120.

In the configuration shown in Fig. 10A, the plurality of RF switch transistors 116A are situated beneath the die pad 120 and the UTM 210 within the top die 102A of the 3DIC 200. The positioning of the transistors 116A directly under the die pad 120 and the UTM 210 creates a configuration in which the metal layers, particularly the UTM 210, interact electrically with the transistor layer 316A below. The arrangement of Fig. 10A leads to the formation of parasitic coupling capacitance between the RF switch transistors 116A and the die pad 120, as well as the UTM 210. Parasitic capacitance occurs because the metal components, including the die pad 120 and the UTM 210, act as one plate of a capacitor, while the transistor layer 316A with the plurality of RF switch transistors 116A below forms the other plate. The dielectric material (e.g., dielectric layer 106A) between them, which could be an insulating layer or simply air, acts as the dielectric medium of this unintended capacitor. The parasitic coupling capacitance is undesirable because it introduces an unwanted electrical interaction that can degrade the performance of the RF switch transistors. Specifically, this capacitance can affect the off-state capacitance (COFF) of the transistors 116A, 116B, which is a critical parameter for the proper functioning of RF switches. Increased parasitic capacitance can lead to signal loss, reduced switching speed, and increased noise, thereby compromising the efficiency and effectiveness of the RF switch in handling high-frequency signals. The presence of UTM 210 may further exacerbate this issue due to its significant size and proximity to the transistors 116A, which may increase the capacitance and the associated negative effects.

**Fig. 10B** illustrates a layout of a 3DIC 200 configured as a Single-Pole Double-Throw (SPDT) for tuner application as viewed in a design tool. It has a common GND and two separate branches. Each branch may comprise circuit elements described with reference to Fig. 10A. A SPDT switch is a type of switch with one input (the "pole") and two possible outputs (the "throws"). The "pole" would be the common input connection, and the switch can connect this input to one of two output branches or both. The branches have a similar layout. Each branch may comprise a stack of transistors. Layer 316A on the left corresponds to a transistor layer 316A of left branch. Layer 316A on the right corresponds to a transistor layer 316A of right branch. An area between the two branches may be mainly free of structures. Here, wiring and resistors may be placed, for example. A distance between the branches may avoid RF-coupling between the two branches. In a 3DIC, one can imagine respective further transistor layers underneath the left and right transistor layers 316A, such as left and right transistor layers 316B. Respective UBMs 207 may be placed above transistor layers 316A. Circle 302 designates an opening for UBM 207 in the passivation layer(s) 118; 208. Circle 304 designates the UBM 207 and the square designates an abstract object representing a region within which the UBM 207 is inscribed.

The plurality of RF switch transistors 116A of left and right branch are arranged in a grid pattern within the respective transistor layers 316A underneath connection pad 120. The view in Fig. 10B shows a dense and uniform distribution of the RF switch transistors 116A, with no areas where transistors have been omitted. This layout maximizes the available space for transistors but at the expense of increased parasitic capacitance, which could negatively impact the RF performance of the IC.

The present disclosure proposes a strategic modification in the layout of the transistor layer 316A with the plurality of RF switch transistors 116A to lower the parasitic capacitance and mitigate its associated negative effects on the performance of the RF switch transistors. Specifically, the present disclosure proposes a cut-out area within the transistor layer 316A that is deliberately left free of transistors directly beneath the die pad 120 and/or the UTM 210. Removing transistors from this area may reduce the coupling between the transistors 116A and the metal components above them, thereby decreasing the overall parasitic capacitance.

This reduction in parasitic capacitance may help to preserve the integrity of the electrical signals passing through the RF switch transistors, improving their off-state capacitance (COFF) and enhancing their switching performance. As a result, embodiments may not only minimize signal loss and noise but also allow the RF switches to operate more efficiently at higher frequencies. The strategic omission of transistors in the area beneath the pad 120 and UTM 210 may thus provide a simple yet effective solution to the problem of unwanted capacitive coupling, ensuring better overall functionality of the integrated circuit.

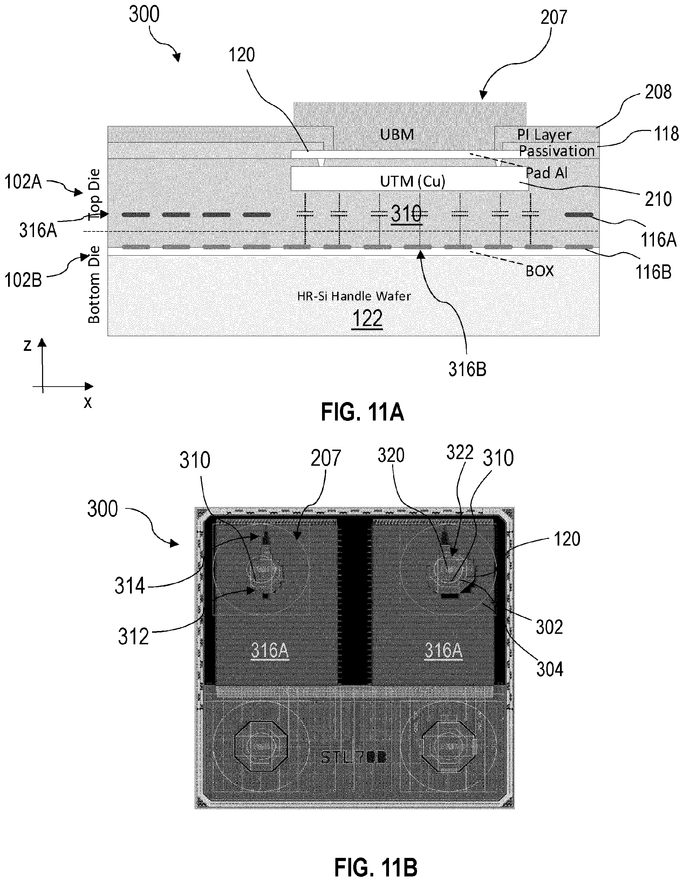

In **Fig. 11A****,** a side view of a 3DIC 300 is depicted with a key modification compared to 3DIC 200 of Fig. 10A: the introduction of a cut-out area 310 in the layer 316A of transistors 116A. In the embodiment of Fig. 11A, the cut-out area 310 is positioned directly beneath the UTM 210 and the die pad 120, within the top die 102A. Unlike the configuration shown in Fig. 10A, where transistors are uniformly distributed across the entire transistor layer, the cut-out area 310 in the transistor layer 316A is devoid of any transistors. The cut-out area 310 may be introduced as a part of a layout design phase. This means the transistors in the layer 316A maybe strategically omitted during the design process, before fabrication. Thus, there is no physical removal of transistors after fabrication. The "cutout" process may be entirely a layout-based design optimization that takes place during the design phase, before the chip is manufactured.

The cut-out area 310 is designed to extend vertically through the thickness of the transistor layer, creating a space free of transistors directly under the UTM 210. The remaining portions of the transistor layer, outside the lateral boundaries of the cut-out area 310, still contain transistors 116A that extend horizontally within the top die 102A. The UTM 210 spans across the cut-out area 310, but the absence of transistors beneath UTM 210 in the cut-out area 310 may reduce the parasitic coupling capacitance that would otherwise occur between the UTM 210 and the transistor layer.

The arrangement of the cut-out area 310 beneath UTM 210 and die pad 120 may ensure that while the structural integrity and overall layout of the 3DIC 300 are maintained, the electrical performance is enhanced by minimizing the undesired capacitive interactions between the metal components and the transistors 116A. This deliberate omission of transistors within the cut-out area 310 may lead to an improved RF performance of the 3DIC 300 by reducing parasitic effects that could degrade the signal integrity.

**Fig. 11B** illustrates a layout of a 3DIC 300 configured as SPDT for RF tuner application as viewed in a design tool. Each branch may comprise circuit elements described with reference to Fig. 11A. In Fig. 11B, left and right transistor layers 316A each have a respective cut-out area 310. Respective UBMs may be placed above transistor layers 316A. Circle 302 designate respective openings for UBMs 207 in the passivation layer(s) 118; 208. Circles 304 designates the respective UBMs 207 and the square is an abstract object designating region within which the UBM 207 is inscribed. The octagonal shapes designate the respective left and right pads 120, which are, due to the design tool, illustrated as being located beneath the left and right transistor layers 316A. This is a by-product of the design tool, and the pad 120 would be located above in a top view, in conformity with Fig. 11A.

Similar to Fig. 10B, the SPDT shown in Fig. 11B may act as a RF-tuner and its input (common port) can be connected to both its output ports (left and right) at the same time. The switch can direct an input signal to either the left or the right output port, or, to both simultaneously. The output ports of the SPDT switch may each be connected to a capacitor. Capacitors may be used in RF-tuners because they affect the resonance frequency of the circuit, thus tuning the RF signal. The SPDT switch can connect the common port to either the left output port or the right output port, depending on the desired capacitance value (C) for tuning. When the common port is connected only to the left output port, the capacitance from the capacitor connected to the left port is applied to the common port. When the common port is connected only to the right output port, the capacitance from the capacitor on the right port is applied. The SPDT switch can also connect both output ports to the common port at the same time, effectively creating a parallel connection of the two capacitors. In this case, the resultant capacitance is the sum of the capacitances from the two ports, giving a third tuning option. This flexibility may allow the RF-tuner to adjust the capacitance and, in turn, the tuning of the RF signal, depending on which combination is selected. The different capacitance values may alter the tuning frequency of the circuit, enabling the RF-tuner to cover a wider range of frequencies.

In the illustrated view of Fig. 11B, compared to Fig. 10b, left and right cut-out areas 310 are clearly visible within an otherwise uniform layout of the layers 316A of transistors 116A. These cut-outs 310 are located directly beneath left and right die pads 120 and UTMs 210. The cut-out areas 310 are represented as voids or spaces within the densely packed layers 316A of transistors 116A, indicating that no transistors are present in these regions. This absence of transistors reduces the parasitic capacitance that would typically occur if transistors were placed directly under the metal layers. The remaining portions of the transistor layers 316A, outside these cut-out regions, continue to contain transistors, ensuring that the overall functionality of the IC is maintained.

The view in Fig. 11B indicates that the cut-out areas 310 may be centrally aligned with the die pads 120, and they may have a geometric shape that is consistent with the underlying design needs to minimize capacitive effects. In other words, a cut-out area 310 may extend radially from a center 320 of the connection pad 120 as seen along the thickness direction (z-direction). The rest of the die 102A may exhibit a steadily-organized layout, with the transistor layers 316A filling the majority of the die's surface, except for the cut-out regions 310. This design choice may effectively balance the need to reduce parasitic capacitance while preserving the operational capabilities of the transistors in the surrounding areas.

The cut-out areas 310, as depicted in Fig. 11A, 11B, can be designed with various geometric shapes to optimize the reduction of parasitic capacitance while maintaining the integrity and performance of 3DIC 300. The specific shape of the cut-out areas 310 is not limited to a single form; instead, they can be adapted to meet different design requirements and constraints.

One potential geometric configuration for the cut-out areas 310 is, as shown in Fig. 11B, a "drop" configuration, where the cut-out area 310 features a main portion 312 (lower portion of cut-out area 310 in Fig. 11B) with a generally circular or elliptical shape, accompanied by a secondary portion 314 (upper portion of cut-out area 310 in Fig. 11B) which stretches away from the main portion 312. For instance, the secondary portion 314 tapers away from the main portion. This drop-shaped cut-out 310 can help to fine-tune the balance between minimizing capacitance and maintaining sufficient transistor coverage. The secondary portion 314 of the drop shape allows for a gradual reduction in transistor density, which might be beneficial in controlling the distribution of electrical fields and further optimizing RF performance. As shown in Fig. 11B, the left and right "drop" configurations do not need to be identical due to desired functionalities to achieve.

Another potential geometric configuration for the cut-out areas 310 is a radial design, where the cut-out extends outward from the center of the connection pad 120. This radial arrangement could be circular, elliptical, or polygonal, with the primary objective being to maximize the distance between the metal layers, such as the UTM 210 and the underlying transistors 116A, to effectively reduce the coupling capacitance. A circular cut-out, for instance, would provide a symmetrical reduction in capacitance around the pad 120, ensuring uniform performance across the entire RF switch.

In some embodiments, the cut-out area 310 may take on a rectangular or polygonal shape. A rectangular cut-out could be aligned with the edges of the connection pad 120 and/or UTM 210, offering an efficient method to reduce capacitance in a specific directional orientation. Polygonal shapes, such as hexagons or octagons, might be used to more precisely tailor the capacitance reduction to specific areas under the pad, depending on the desired electrical characteristics and the layout of the transistor layer.

The size of the cut-out area 310 can also vary relative to the size of the connection pad 120. For example, in some cases, the cut-out area 310 may be smaller than an area 322 of the pad 120 and/or UTM 210, focusing the reduction of capacitance on the region directly under the pad 120 and/or UTM 210 while leaving some transistors 116A in place at the edges to support additional functionality. Conversely, a larger cut-out area 310 that exceeds the size of the pad 120 and/or UTM 210 could be employed when a more extensive reduction in parasitic effects is needed, particularly in scenarios where the capacitance needs to be minimized to the greatest extent possible.

These alternative geometric shapes and sizes for the cut-out areas 310 may provide flexibility in the IC design, allowing for targeted optimization of electrical performance based on the specific requirements of the application. By carefully selecting and designing the shape of the cut-out areas, it is possible to achieve a more refined balance between reducing parasitic capacitance and preserving the operational capabilities of the transistor layer, ultimately leading to improved RF switch performance and more reliable IC operation.

In Fig. 11A, the schematic illustrates the presence of a reduced parasitic capacitance between the UTM 210 and the transistors 116B in the bottom die 102B. While both instances of parasitic capacitance can impact the performance of the integrated circuit (IC), the capacitance between the UTM 210 and the transistors in the top die 102A is generally more critical. This is because the top die 102A is directly adjacent to the UTM 210, leading to a stronger and more immediate capacitive coupling. The closer proximity results in a higher capacitance, which can more significantly degrade the electrical characteristics of the RF switch, particularly by adversely affecting the off-state capacitance (COFF) and the overall RF performance. In contrast, the transistors 116B in the bottom die 102B are separated from the UTM 210 by a greater distance and multiple intervening layers, including the top die 102A. This additional separation inherently reduces the strength of the capacitive coupling, making the parasitic capacitance between the UTM 210 and the bottom die transistors 116B less impactful on the overall performance of the IC 300. The reduced capacitance at this level means that the negative effects on signal integrity, such as increased noise and signal loss, are less pronounced compared to the capacitance between the UTM 210 and the transistors 116A in the top die 120A.

However, despite this lower criticality, there is an option to further optimize the design by additionally providing a cut-out area in the transistor layer 316B of the bottom die 102B. Implementing such a cut-out would follow a similar principle as the cut-out 310 in the top die 102A, aiming to further reduce any residual parasitic capacitance that might still influence the IC's performance. By strategically omitting transistors directly beneath the UTM 210 in the bottom die 102B, the design could achieve an additional reduction in unwanted capacitive effects, thereby ensuring even greater signal clarity and stability across the entire 3DIC 300.

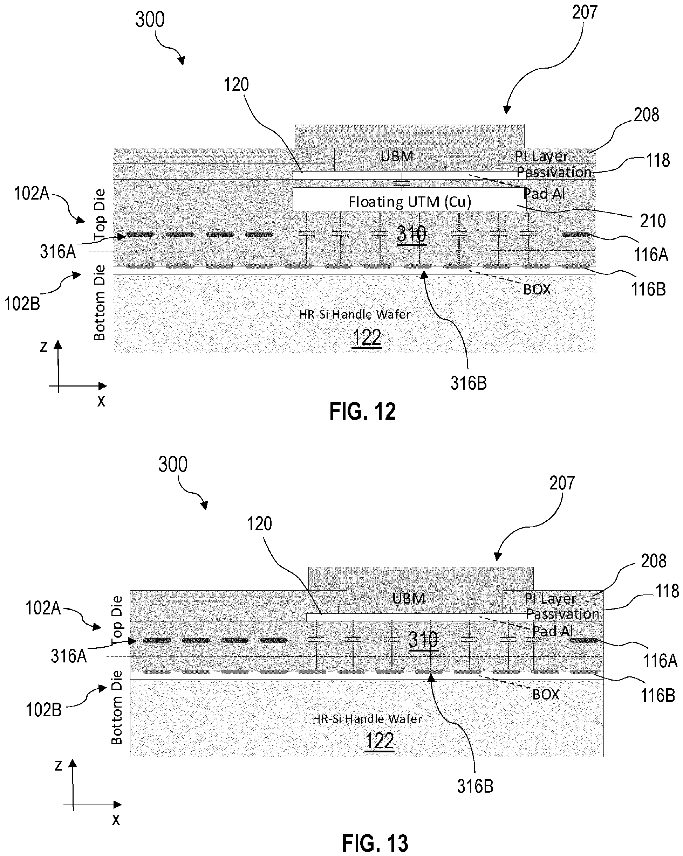

**Fig. 12** presents an alternative embodiment of the 3DIC 300 where UTM 210 is configured to be floating, as opposed to the embodiment shown in Fig. 11A, where UTM 210 is electrically connected to the die pad 120. In the floating configuration depicted in Fig. 12, UTM 210 is not directly connected to any electrical component or circuit path within the IC 300. This isolation effectively decouples the UTM 210 from the active electrical circuitry.

The primary difference between these two configurations lies in the electrical interaction between the UTM 210 and the surrounding components. In Fig. 11A, where the UTM 210 is electrically coupled to the die pad 120, UTM 210 actively participates in the electrical circuit, potentially contributing to parasitic capacitance issues that can negatively affect the performance of the RF switch transistors 116A. The direct electrical connection can lead to increased capacitive coupling with the transistors 116A, particularly those in the top die 102A, thereby degrading the RF performance by introducing unwanted capacitive effects that alter the intended signal characteristics.

In contrast, the floating UTM configuration in Fig. 12 may mitigate these issues by removing the UTM 210 from the electrical circuit. This floating state may reduce the capacitive coupling between the UTM 210 and the transistor layers (both 116A in the top die and 116B in the bottom die), as the UTM 210 no longer acts as a conductive path that could interact with the electrical fields generated by the transistors. Consequently, this configuration may help to further reduce parasitic capacitance, leading to improved signal integrity and reduced noise within the RF switch.

**Fig. 13** presents a modified embodiment of the 3DIC 300 where the UTM layer 210, as previously shown in Fig. 11A and 12, is entirely absent beneath the die pad 120. This is a departure from the design in Fig. 11A and 12, where the UTM 210 was present directly beneath the pad 120, contributing to both electrical conductivity and potential parasitic capacitance issues.

A notable difference in this configuration is the complete elimination of the UTM under the pad 120, which directly impacts the parasitic capacitance between the pad 120 and the underlying transistor layer 316A. In the absence of the UTM, there is no longer a large conductive metal layer in close proximity to the transistors 116A, which may further reduce the parasitic capacitance. This reduction in capacitance can lead to an improvement in the electrical performance of the RF switch transistors 116A, particularly by lowering the off-state capacitance (COFF) and reducing unwanted capacitive coupling that could distort the signal.

The removal of the UTM also means that the IC might experience slightly different thermal and electrical characteristics, as the UTM in the previous designs may play a role in heat dissipation and electrical conduction. However, this trade-off may be justified by the gains in reducing parasitic capacitance, which is critical for ensuring high-frequency performance and signal integrity in RF applications.

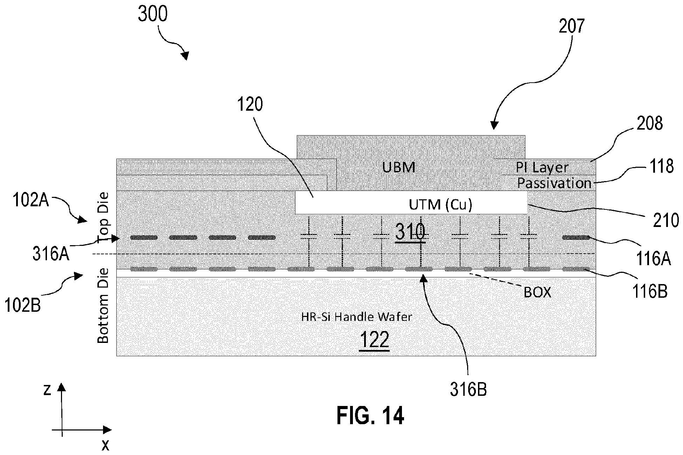

In **Fig. 14****,** the schematic shows a modified embodiment of the 3DIC 300 where the UTM 210 is positioned underneath the under-bump metallization (UBM) 207 instead of the die pad. This means that the UTM 210 is in electrical contact to the UBM and is electrically connected to other components of the circuit. In the embodiment of Fig. 14, the UTM may also be considered as connection pad 120.

This arrangement differs from the previous embodiments, where the UTM was positioned under the die pad 120. By placing the UTM underneath the UBM 207, the primary purpose of the UTM in this configuration shifts towards providing mechanical support to the UBM 207 and the solder balls (not shown), which are needed for connecting 3DIC 300 to external components. The increased distance between the UTM 210 and the transistor 116A/B may reduce its interaction with the electrical fields generated by the transistors 116A,B, thereby minimizing parasitic capacitance while still offering the necessary mechanical stability. An advantage of the embodiment in Fig.14 compared to the one in Fig.12 is a cost reduction.

The die pad 120 (not shown in Fig. 14) may be positioned laterally shifted, or offset, from UBM 207. This means that rather than being directly aligned with the UBM 207, the die pad 120 may be located at a different position on the die, away from the vertical alignment. To facilitate electrical connectivity between the laterally shifted die pad 120 and the UBM 207, a redistribution structure may be employed. The redistribution structure comprises conductive traces or layers that extend from the die pad 120 to the UBM 207, effectively rerouting the electrical connection across the surface of the die. The redistribution structure ensures that even though the die pad is not directly beneath the UBM 207, the electrical signals can still be transferred efficiently and reliably between these two components. The UBM 207 could be placed on the redistribution layer. For mechanical reasons, UTM 210 could be placed below the UBM 207. In this embodiment, the UTM 210 could be electrically isolated from the UBM 207 by dielectric layers, e.g. the passivation 118 and/or PI Layer 208. This results in a further reduction of the parasitic capacitance between the UBM 207 and the transistors 116A/B.

Various embodiments of the present disclosure propose a layout method for improving the off-state capacitance of 3DIC integrated antenna tuners. A problem addressed by the present disclosure is the high parasitic coupling capacitance that occurs when switch transistors are placed directly beneath the RF pad area on the top die, which may significantly degrade RF performance. The proposed solution involves modifying the transistor layer by creating a cut-out area directly under the RF pad. This area is free of transistors, thereby reducing the parasitic capacitance and improving the overall RF performance of the switch. This method may enhance the off-state capacitance (COFF) while balancing the trade-off between on-resistance (RON) and chip area. The cut-out design is versatile, allowing different shapes and sizes depending on the specific application requirements. Additionally, the present disclosure explores various configurations, such as the inclusion of a floating ultra-thick metal (UTM) layer, which may further minimize parasitic effects by isolating it from the active circuit. The present disclosure also considers mechanical implications, such as the UTM's role in providing structural support for the under-bump metallization (UBM) and solder balls, particularly when the UTM is absent or repositioned.

The aspects and features described in relation to a particular one of the previous examples may also be combined with one or more of the further examples to replace an identical or similar feature of that further example or to additionally introduce the features into the further example.

It is further understood that the disclosure of several steps, processes, operations or functions disclosed in the description or claims shall not be construed to imply that these operations are necessarily dependent on the order described, unless explicitly stated in the individual case or necessary for technical reasons. Therefore, the previous description does not limit the execution of several steps or functions to a certain order. Furthermore, in further examples, a single step, function, process or operation may include and/or be broken up into several sub-steps, -functions, -processes or -operations.

If some aspects have been described in relation to a device or system, these aspects should also be understood as a description of the corresponding method. For example, a block, device or functional aspect of the device or system may correspond to a feature, such as a method step, of the corresponding method. Accordingly, aspects described in relation to a method shall also be understood as a description of a corresponding block, a corresponding element, a property or a functional feature of a corresponding device or a corresponding system.

The following claims are hereby incorporated in the detailed description, wherein each claim may stand on its own as a separate example. It should also be noted that although in the claims a dependent claim refers to a particular combination with one or more other claims, other examples may also include a combination of the dependent claim with the subject matter of any other dependent or independent claim. Such combinations are hereby explicitly proposed, unless it is stated in the individual case that a particular combination is not intended. Furthermore, features of a claim should also be included for any other independent claim, even if that claim is not directly defined as dependent on that other independent claim.

## Claims

1. An integrated circuit, IC (300), comprising,
at least one die (102A) comprising a transistor layer (316A) including a plurality of transistors (116A);
a connection pad (120) disposed on the die (102), the connection pad (120) overlapping the transistor layer along a thickness direction of the IC,
wherein the transistor layer comprises a cut-out area (310) free of transistors (116A), the cut-out (310) area facing the connection pad (120) along said thickness direction.

2. The IC (300) of claim 1, wherein the plurality of transistors (116A) is arranged in a grid pattern within the transistor layer, the cut-out area (310) being formed as an absence of transistors in predetermined portions of the grid pattern.

3. The IC (300) of any one of the previous claims, wherein the cut-out area (310) extends radially from a center (320) of the connection pad (120) as seen along said thickness direction.

4. The IC (300) of any one of the previous claims, wherein the cut-out area (310) is smaller than an area (322) of the connection pad (120).

5. The IC (300) of any one of claims 1 to 3, wherein the cut-out area (310) is larger than an area of the connection pad (120).

6. The IC (300) of any one of the previous claims, wherein the cutout area (310) is only partial, the transistor layer comprising at least one transistor facing the connection pad (120) along the thickness direction.

7. The IC (300) of any one of the previous claims, wherein the cutout area (310) presents a drop configuration with a main portion (312) exhibiting a generally circular or elliptical shape and a secondary portion (314) stretching from the main portion and exhibiting a shape which tapers away from the main portion.

8. The IC (300) of any one of claims 1 to 6, wherein the cut-out area (310) has a circular, rectangular, or polygonal shape.

9. The IC (300) of any one of the previous claims, further comprising
an ultra-thick metal, UTM (210), arranged between the connection pad (120) and the transistor layer, wherein a thickness of the UTM (210) is greater than a thickness of the connection pad.

10. The IC (300) of claim 9, wherein the UTM (210) is electrically connected to the connection pad (120).

11. The IC (300) of claim 9, wherein the UTM (210) is floating.

12. The IC (300) of any one of the previous claims, further comprising
an under-bump metallization, UBM (207), for a terminal of the IC, the UBM (207) overlapping the connection pad (120) along the thickness direction.

13. The IC (300) of any one of the previous claims, wherein the IC is a three-dimensional, 3D, IC further comprising a second die (102B) coupled to said die (102A), the second die (102B) comprising a second transistor layer (316B) including a second plurality of transistors (116B) and forming a transistor stack with the transistor layer.

14. The IC (300) of any one of claims 1 to 12, wherein the IC is a two-dimensional, 2D, IC.

15. An antenna tuner comprising the IC (300) of any one of the previous claims, the transistor layer forming all or part of a radiofrequency, RF, switch.
